# EUROPEAN PATENT SPECIFICATION

(11) **EP 2 445 325 B1**
(45) Date of publication and mention of the grant of the patent: **14.12.2022**
(21) Application number: 11008144.5
(22) Date of filing: 07.10.2011
(51) Int. Cl.: H05K 5/00

(54) **Electronic control device**
Elektronische Steuervorrichtung
Dispositif de commande électronique

(30) Priority: 19.10.2010 JP 2010234514
(43) Date of publication of application: 25.04.2012
(73) Proprietor: Hitachi Astemo, Ltd., Hitachinaka-shi, Ibaraki (JP)
(72) Inventor: Suzuki, Yosuke, Shioya-gun Tochigi, 3291233 (JP); Takase, Tooru, Shioya-gun Tochigi, 3291233 (JP)
(74) Representative: v. Bezold & Partner Patentanwälte - PartG mbB

(56) References cited:
- US-A1- 2005 287 841
- US-B2- 7 686 623

## Description

### TECHNICAL FIELD

The present invention relates to electronic control devices and, more particularly, to an electronic control device provided with a connector that is mounted on a substrate and fitted to a case.

### BACKGROUND ART

In recent years, functions required for vehicles, such as automobiles, have been highly sophisticated and with such a high sophistication, functions, required for electronic equipments installed on the vehicles, have also been remarkably sophisticated. This results in an increase in the number of various electronic equipments and, hence, a need has been arisen for such electronic equipments to be miniaturized in size and intensified in structure for installation on the vehicles.

At the same time, these electronic equipments, installed on the vehicles, have been much more likely to be formed with structures in which a connector, a semiconductor device and the like are mounted on a substrate which is accommodated in a case. In such a situation, with a view to having their improved productivity, the connector and the substrate, on which the connector and the like are mounted, has been required to be rapidly and reliably positioned with respect to the case for accommodation into the case.

In this context, the US 2005/0287841 A1 relates a housing case for an electronic circuit board, on which components such as connectors are mounted, wherein in the housing case there are provided a pair of guide rails that form a guide path when the board is inserted in the case and a holder holding the connectors mounted on the board. Moreover, the guide rails are disposed in a position that does not interfere with the board when the connector is held by the holder, thereby enabling to easily receive the board to be accurately fixed at a predetermined position, while preventing an excessive twisting/shaking force from concentrating at a joint where components are joined to the board, when mating connector is inserted to or removed from the connectors.

Furthermore, the US 7,686,623 B2 discloses an electronic device that includes a printed circuit board, a connector mounted on the printed circuit board, and a case housing the printed circuit board. The case has an opening portion on one side thereof and the housing covers the opening portion. The case includes a wall having a case-side fixing part and a case-side engaging part at a portion adjacent to the opening portion. The housing has a housing-side fixing part and a housing-side engaging part. The case-side fixing part engages with the housing-side fixing part for fixing the housing to the case. The case-side engaging part engages with the housing-side engaging part for restricting the portion of the case adjacent to the opening portion from separating from the housing.

Japanese Patent Application Laid-Open Publication No. 2006-13059 relates to an accommodating case for an electronic circuit substrate. Specifically, there are disclosed that the accommodating case is provided with a pair of guide rails forming guide paths for the electronic circuit substrate and a holder section for holding a connector of the electronic circuit substrate, and also, when the connector is held by the holder section, the pair of guide rails are disposed in positions not to conflict with the electronic circuit substrate.

### SUMMARY OF INVENTION

However, according to studies conducted by the present inventors, although the structure disclosed in Japanese Patent Application laid-Open Publication No. 2006-13059 contemplates the provision of the pair of guide rails disposed in the position not to conflict with the electronic circuit substrate so as to allow the electronic circuit substrate, mounting the connector thereon, to be simply and precisely accommodated in the case, the holder section per se is located inside the case. Thus, it is conceived that a so-called tall component, mounted on the electronic circuit substrate, tends to undesirably interfere the holder section, and this makes it incapability for the tall component to be mounted below the holder section.

Meanwhile, in order for such a tall component not to interfere the holder section, a specified mounting space for the tall component, which is to be mounted, separately needs to be provided in a position spaced from a circumference of the holder section. This results in a growing tendency of an increase in sizes of both the electronic circuit substrate and the accommodating case.

That is, electronic control devices stand in a state that expects a novel structure for miniaturizing a device structure, while enabling a substrate, on which various electronic components and a connector are mounted, to be rapidly and reliably inserted in and attached to a case and ensuring a mounting space especially for a tall component.

The present invention has been completed upon various studies set forth above and has an object to provide an electronic control device formed in a simplified structure with a capability of causing a substrate, on which various electronic components and a connector are mounted, to be immediately and reliably inserted in and attached to a case, while enabling a device structure to be miniaturized with a mounting space being ensured especially for a tall component.

To achieve the object set forth above, in a first aspect, the present invention provides an electronic control device according to claim 1.

Further aspects of the present invention are provided in dependent claims 2-4.

With the electronic control device of the first aspect of the present invention, the fitting section, allowing the connector to be fitted to the case, has the height with respect to the substrate, which is higher than the height, with respect to the substrate, of the first electronic component serving as the tall component among the plurality of electronic components mounted on the substrate, and the first electronic component is mounted on the substrate in the gap portion defined between the fitting section and the substrate. This enables the substrate, mounting the electronic components and the connector thereon, to be immediately and reliably inserted in and attached to the case, with a simplified structure. Further, this results in a capability of miniaturizing a whole structure of the electronic control device, while ensuring a mounting space especially for the tall component.

With the electronic control device of a second aspect of the present invention, the fitting insertion portion is maintained under the state in which the fitting insertion portion kept in the fitting concave portion is spaced from the case with the state in which the connector is engaged to the case in the engaging section causing the connector to engage the case. This makes it easy for the fitting insertion portion to be inserted to the fitting concave portion, thereby enabling the connector and the substrate, mounting the electronic components and the connector thereon, to be immediately and reliably inserted to and mounted in the case.

With the electronic control device of a third aspect of the present invention, the fitting hold portion of the case includes the stepped portion with which the connector is brought into abutting contact in the entering direction thereof with respect to the case. This makes it possible to position the connector into the case at an early stage of the accommodation thereof, thereby enabling its attaching capability to be improved.

With the electronic control device of a fourth aspect of the present invention, the first electronic component is accommodated in the first accommodating chamber having a relatively large capacity and the second electronic component is accommodated in the second accommodating chamber having a relatively small capacity. This enables the case to be miniaturized, while utilizing the accommodating chambers of the case in an effective way.

### BRIEF DESCRIPTION OF THE DRAWINGS

FIG. 1 is an exploded perspective view of an electronic control device of an embodiment according to the present invention.
FIG. 2 is a perspective view of the electronic control device according to the present embodiment.
FIG. 3 is a vertical cross-sectional view of the electronic control device according to the present embodiment and corresponds to a cross-section taken on line A-A of FIG. 2.
FIG. 4A is a partially vertical cross-sectional view of the electronic control device according to an example not forming part of the invention and corresponds to a cross-section taken on line B-B of FIG. 2.
FIG. 4B shows a structure of a modified form of the present embodiment and corresponds to the cross-section taken on line B-B of FIG. 2.
FIG. 5A is a partially lateral cross-sectional view of the electronic control device according to the present embodiment with a modified form thereof and corresponds to a cross-section taken on line C-C of FIG. 3.
FIG. 5B shows a structure of another modified form of the present embodiment and corresponds to the cross-section on line C-C of FIG. 3.
FIG. 6A is a partially vertical cross-sectional view of the electronic control device according to the present embodiment and corresponds to a cross-section taken on line D-D of FIG. 5A.
FIG. 6B shows a structure of a modified form of the present embodiment and corresponds to the cross-section on line D-D of FIG. 5A.
FIG. 6C shows a structure of another modified form of the present embodiment and corresponds to a cross-section on line E-E of FIG. 5B.
FIG. 7 is a partially exploded perspective view of a structure of another modified form of the electronic control device according to the present embodiment.

### EMBODIMENT FOR CARRYING OUT THE INVENTION

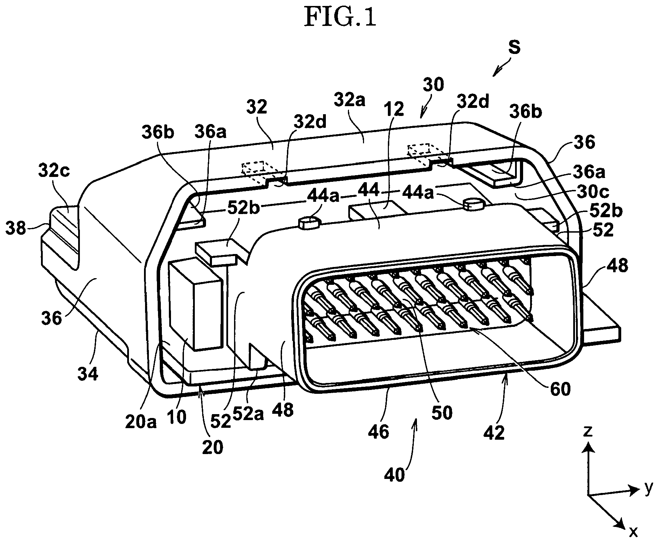

Now, an electronic control device of an embodiment according to the present invention will be described below in detail, suitably with reference to FIGS. 1 to 7 of the accompanying drawings. Throughout the drawings, x-, y- and z-axes constitute a three-axis orthogonal coordinate system, in which a direction along the x-axis corresponds to a longitudinal direction, a direction along the y-axis corresponds to a widthwise direction, and a direction along the z-axis corresponds to a vertical direction, with a direction parallel to an x-y plane corresponding to a horizontal direction.

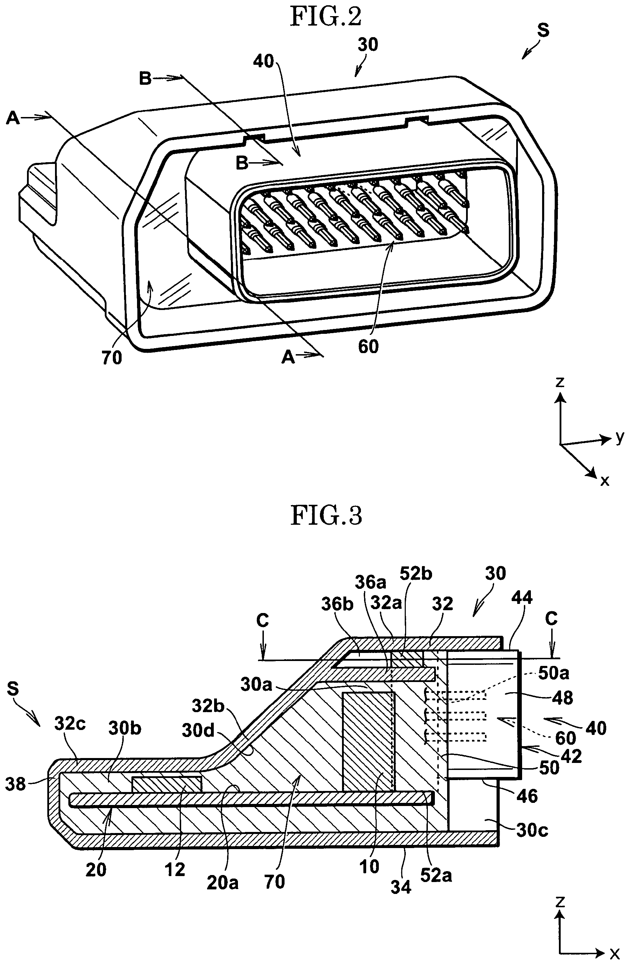

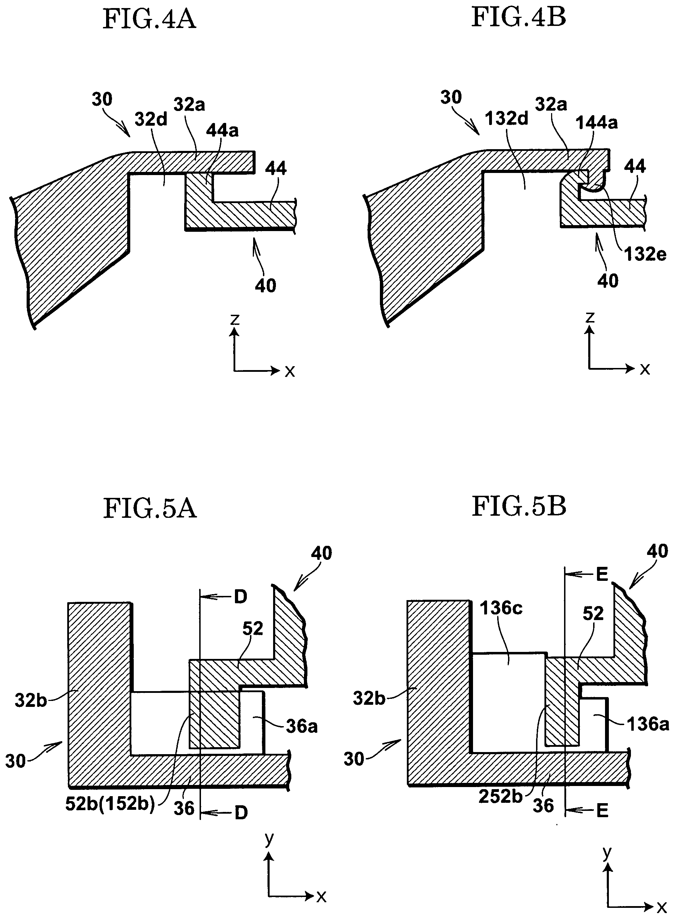

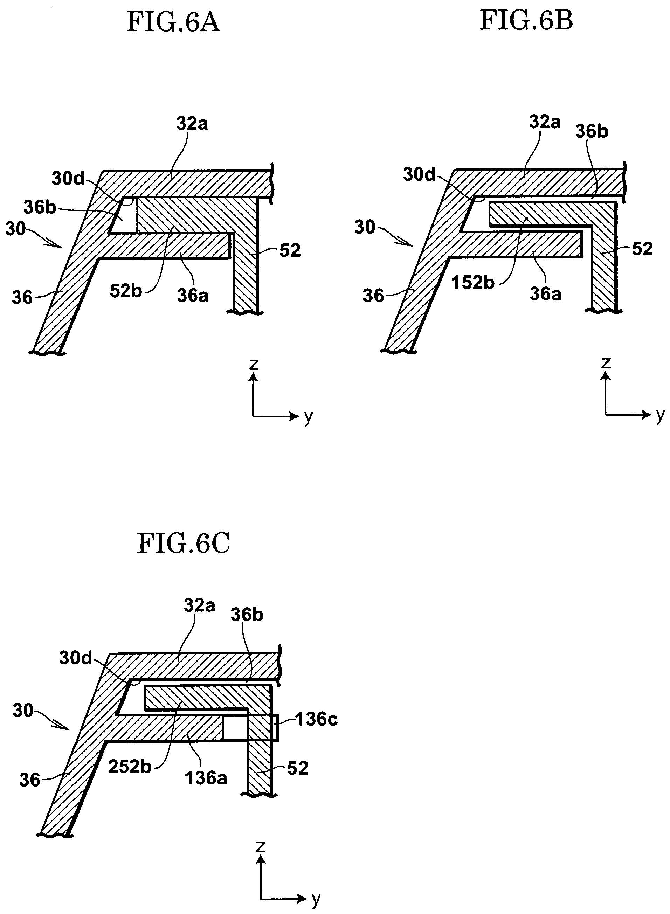

FIG. 1 is an exploded perspective view of an electronic control device according to the present embodiment, and FIG. 2 is a perspective view of the electronic control device according to the present embodiment. FIG. 3 is a vertical cross-sectional view of the electronic control device according to the present embodiment and corresponds to a cross-section taken on line A-A of FIG. 2. FIG. 4A is a partially vertical cross-sectional view of the electronic control device according to an example not forming part of the invention and corresponds to a cross-section taken on line B-B of FIG. 2. FIG. 5A mainly shows a partially lateral cross-sectional view of the electronic control device according to the present embodiment and corresponds to a cross-section taken on line C-C of FIG. 3. FIG. 6A is a partially vertical cross-sectional view of the electronic control device according to the present embodiment and corresponds to a cross-section taken on line D-D of FIG. 5A.

As shown in FIGS. 1 to 3, the electronic control device S is provided with a plurality of electronic components 10 and 12, a substrate 20 on which the plural electronic components 10 and 12 are mounted, a case 30 having accommodating chambers 30a and 30b to accommodate the substrate 20 on which the plurality of electronic components are mounted, and a connector 40 mounted on the substrate 20 to enter from an opening portion 30c of the case 30 into the large accommodating chamber 30a among the accommodating chambers 30a and 30b.

More particularly, among the plural electronic components 10 and 12, the electronic component 10 is a so-called tall component, such as an electrolytic capacitor, and has a height relatively higher with respect to an upper surface 20a of the substrate 20. The remnant electronic component 12 is a so-called surface mount component, such as a CPU (Central Processing Unit), and has a height relatively lower with respect to the upper surface 20a of the substrate 20. Throughout the drawings, further, the electronic components 10 and 12 are shown only in a single component, respectively, but the number of these components is not limited. That is, it may suffice for these components to be appropriately mounted on the substrate 20 and correspondingly accommodated in the accommodating chambers 30a and 30b of the case 30, in a manner described below. Here, the heights of the electronic components 10 and 12 refer to heights measured from the upper surface 20a of the substrate 20 to the tops thereof, respectively.

The substrate 20 is typically a printed-circuit board, though not shown in the drawings, which has pad portions or the like on the upper surface 20a. Under a state where the electronic components 10 and 12 are mounted on the substrate 20, respective leads, which are not shown in the drawings, of the electronic components 10 and 12 are bonded to such pad portions with solder or the like such that the plural electronic components 10 and 12 and the substrate 20 are electrically connected in respective relationships, correspondingly.

The case 30 is typically a molded product, made of synthetic resin, which has the accommodating chambers 30a and 30b in which the substrate 20, mounting the plural electronic components 10 and 12 thereon, are fixedly accommodated.

More particularly, the case 30 is provided with an upper wall 32 and a bottom wall 34 which are vertically spaced in opposition to each other, a pair of sidewalls 36 and 36 which are widthwise spaced in opposition to each other to respectively connect the upper wall 32 and the bottom wall 34, and a front wall 38 which is placed in opposition to the opening portion 30c in the longitudinal direction to connect the upper wall 32 and the bottom wall 34. The upper wall 32 has a high upper wall portion 32a relatively higher in height with respect to the bottom wall 34, an inclined wall portion 32b extending from the high upper wall portion 32a and inclined downward, and a low upper wall portion 32c extending from the inclined wall portion 32b and relatively lower in height with respect to the bottom wall 34. That is, the high upper wall portion 32a, the associated bottom wall 34 and the associated pair of sidewalls 36 and 36 allow the case 30 to define an internal space which forms the large accommodating chamber 30a. The low upper wall portion 32c, the associated bottom wall 34 and the associated pair of sidewalls 36 and 36 allow the case 30 to define an internal space which forms the small accommodating chamber 30b. In addition, the large accommodating chamber 30a is open to the outside through the opening portion 30c. Incidentally, the upper wall 32, the bottom wall 34, each of the sidewalls 36 and the front wall 38 have respective inner surfaces which are respectively assigned to have the same reference numerals 30d, for the sake of convenience.

In correspondence with the large accommodating chamber 30a of the case 30, the high upper wall portion 32a has a pair of guide recesses 32d and 32d which are spaced apart from each other in the widthwise direction and indented upward from the inner surface 30d thereof to be shaped in recess portions extending in the longitudinal direction to connect with the opening portion 30c, respectively. Further, in correspondence with the large accommodating chamber 30a, the sidewalls 36 have fitting hold portions 36a in the form of horizontally protruding plate-like pieces which protrude inward from the inner surfaces 30d thereof into the large accommodating chamber 30a in the widthwise direction, respectively. Here, fitting concave portions 36b are defined between upper surfaces of the fitting hold portions 36a and the respective associated inner surfaces 30d of the high upper wall portion 32a, the inclined wall portion 32b and the sidewalls 36, respectively.

The connector 40 is provided with a housing 42 typically in the form of a molded product made of synthetic resin. The housing 42 is provided with an upper wall 44 and a bottom wall 46 which are vertically spaced in opposition to each other, a pair of sidewalls 48 and 48 which are spaced in opposition to each other in the widthwise direction to connect the upper wall 44 and the sidewalls 44, respectively, and a front wall 50 which connects the upper wall 44 and the bottom wall 46 at a front end of the housing 42.

More particularly, the upper wall 44 of the connector 40 has a pair of protrusions 44a and 44a which are spaced apart from each other in the widthwise direction and protruded upward from an upper surface thereof. When the substrate 20, on which the plural electronic components 10 and 12 and the connector 40 are mounted, is accommodated in the case 30, as shown in FIG. 4A, the protrusions 44a and 44a are guided into the associated guide recesses 32d and 32d of the case 30, respectively. Then, when such a substrate 20 is completed in accommodation to the case 30, the protrusions 44a and 44a are brought into abutting contact with the deepest areas of the guide recesses 32d and 32d in the frontward direction, respectively. This determines a longitudinal and widthwise position of the connector 40 with respect to the case 30, i.e., a longitudinal and widthwise position of the substrate 20, mounting such a connector 40 thereon, with respect to the case 30.

The connector 40 has extending walls 52 that extend forward from the sidewalls 48 and beyond the front wall 50, respectively. The extending walls 52 have bottom surfaces 52a held in abutting contact with the upper surface 20a of the substrate 20, respectively. Though not shown in the drawings, the extending walls 52 have leg portions that are inserted to through-bores formed in the substrate 20 such that a position of the connector 40 is determined in the vertically direction and the like with respect to the substrate 20 in a complementary fashion.

The extending walls 52 of the connector 40 have fitting insertion portions 52b in the form of horizontal plate-like pieces which protrude outward from the upper portions thereof, respectively. When the substrate 20, mounting the plural electronic components 10 and 12 and the connector 40 thereon, is accommodated into the case 30, as shown in FIGS. 5A and 6A, the fitting insertion portions 52b are inserted to the associated fitting concave portions 36b of the case 30, respectively. Then, when such a substrate 20 is completed in accommodation to the case 30, upper surfaces and lower surfaces of the fitting insertion portions 52b are brought into abutting contact with and sandwiched between the inner surface 30d of the high upper wall portion 32a and the upper surface of the fitting hold portion 36a within the case 30, respectively. This determines a vertical position of the connector 40 with respect to the case 30, i.e., a vertical position of the substrate 20, mounting such a connector 40 thereon, with respect to the case 30. When this takes place, the fitting insertion portions 52b may be held in contact with the respective associated inner surfaces 30d of the inclined wall portion 32b and the sidewalls 36.

That is, the fitting insertion portions 52b and the associated fitting concave portions 36b and, in addition, the associated areas of the fitting hold portions 36a, the high upper wall portion 32a, the inclined wall portion 32b and the sidewalls 36 which constitute such fitting concave portions 36b define a fitting section respectively in corporation to allow the connector 40 to be fitted to the case 30. Concurrently, the electronic component 10 in the form of the tall component is accommodated in the large accommodating chamber 30a of the case 30 while standing upright at a laterally outside and adjacent area with respect to at least one of the extending walls 52. When this takes place, the electronic component 10 is placed below the fitting hold portions 36a and mounted in a gap portion defined between the lower surface of the fitting hold portion 36a, forming the lowermost element of the associated fitting portion, and the upper surface 20a of the substrate 20. Here, the lower surface of the fitting hold portion 36a of such a fitting portion is distanced from the upper surface 20a of the substrate 20 with a height which is set to be higher than a height, with respect to the upper surface 20a of the substrate 20, of the highest top portion of the electronic component 10 in the form of the tall component. Incidentally, the fitting insertion portions 52b per se may be arranged to overlap the electronic component 10 in the longitudinal direction and the like in an area above the electronic component 10 or not to overlap the same in such a fashion.

The front wall 50 of the connector 40 has a plurality of insertion holes 50a, to which a plurality of pins of a terminal 60 are inserted, respectively. Under a state in which the connector 40 is mounted on the substrate 20, one ends of the plural pins of the terminal 60 are connected to associated connecting portions of the substrate 20 though not shown in the drawings, respectively. Incidentally, the other ends of the plural pins of the terminal 60 are able to be connected to associated connecting portions of mating connector though not shown in the drawings, respectively. Here, the fitting section, composed of the fitting insertion portions 52b, the fitting hold portion 36a and the like, has a height determined to be further relatively higher. This allows the extending walls 52 to be set in large sizes so as to completely cover the plural pins of the terminal 60 as viewed in the y-axis direction such that the plural pins can be further reliably protected, respectively.

A filled resin layer 70 is filled in the internal areas of the accommodating chambers 30a and 30b of the case 30, while permitting a part of the connector 40 to be exposed to the outside. That is, when the substrate 20, on which the plural electronic components 10 and 12 and the connector 40 are mounted, is accommodated in the case 30 to be fixedly attached to an attachment section of the case 30 which is not shown in the drawings, filling material is filled into and solidified in the internal areas of the accommodating chambers 30a and 30b of the case 30, while permitting the partial portion of the connector 40 to be exposed to the outside, thereby forming the filled resin layer 70.

When manufacturing the electronic control device S of such a structure set forth above, as shown in FIG. 1, first, the plural electronic components 10 and 12 and the connector 40 are mounted on the substrate 20, respectively, after which one end of the substrate 20 is progressively inserted from the opening portion 30c of the case 30 into the insides of the accommodating chambers 30a and 30b. When this takes place, the protrusions 44a and 44a, formed on the upper wall 44 of the connector 40, are correspondingly guided into the associated guide recesses 32d and 32d of the case 30 and also, the fitting insertion portions 52b, formed on the upper portion of the extending walls 52 of the connector 40, are guided into the associated fitting concave portions 36b of the case 30, respectively. In this case, the electronic component 10 in the form of the tall component has no interference to the lower surface of the fitting hold portion 36a.

Next, the protrusions 44a and 44a are respectively brought into abutting contact with the deepest areas of the guide recesses 32d and 32d to define the position of the connector 40 in the longitudinal direction and in the widthwise direction with respect to the case 30, i.e., the position of the substrate 20 in the longitudinal direction and the widthwise direction with respect to the case 30. Further, upper and lower surfaces of the fitting insertion portions 52b are sandwiched between the inner surface 30d of the high upper wall portion 32a and the upper surface of the fitting hold portion 36a of the case 30 in abutting contact therewith. This allows the connector 40 to be positioned with respect to the case 30 in the vertical direction and, in turn, the substrate 20 is determined in the vertical position with respect to the case 30. Thus, the substrate 20, on which the plural electronic components 10 and 12 and the connector 40 are mounted, is completely accommodated in the case 30. When this takes place, such as a horizontal position of the substrate 20 is also determined by the attachment section of the case 30 and also, the electronic component 10 in the form of the tall component is located below the fitting hold portion 36a in the gap portion defined between the lower surface of the fitting hold portion 36a and the upper surface 20a of the substrate 20, while being mounted on the substrate 20.

Under such a state, further, resin filling material is filled into and solidified in the internal areas of the accommodating chambers 30a and 30b of the case 30 with the partial area of the connector 40 being exposed in such a manner that the filled resin layer 70 is formed, thereby manufacturing the electronic control device S.

The electronic control device S of such a structure set forth above may be conceivably altered in various modifications.

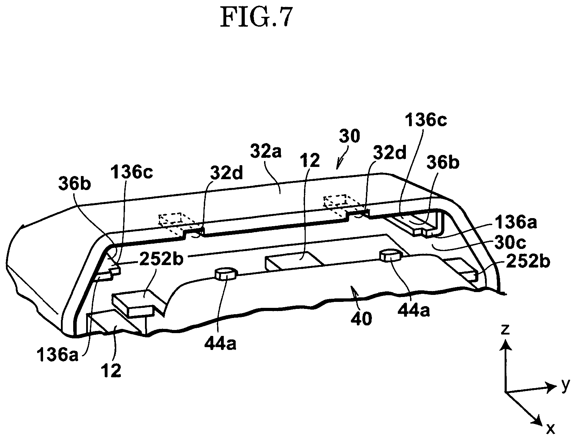

FIG. 4B is a partially vertical cross-sectional view showing a structure of a modified form of the present embodiment and corresponds to FIG. 4A in positional relationship. FIG. 5A is a partially lateral cross-sectional view showing a structure of a modified form of the present embodiment, too. FIG. 5B is a partially lateral cross-sectional view showing a structure of another modified form of the present embodiment and corresponds to FIG. 5A in positional relationship. FIG. 6B is a partially vertical cross-sectional view showing a structure of a modified form of the present embodiment and corresponds to a cross-section taken on line D-D of FIG. 5A. FIG. 6C is a partially vertical cross-sectional view showing a structure of another modified form of the present embodiment and corresponds to a cross-section taken on line E-E of FIG. 5B. Incidentally, a fitting insertion portion 152b of the modified form of the present embodiment is designated by a reference numeral in bracket for the sake of convenience in FIG. 5A. Moreover, FIG. 7 is a partially exploded perspective view showing a structure of another modified form of the electronic control device according to the present embodiment.

For instance, in place of the guide recesses 32d and 32d, set forth above, formed on the inner surface 30d of the high upper wall portion 32a of the case 30 in a way indented upward from the inner surface 30d and extending from the opening portion 30c in the longitudinal direction, as shown in FIG. 4B, guide recesses 132d and 132d may be respectively adopted with structures each in which a hook-shaped protruding portion 132e, which protrudes downward from the upper surface of the associated guide recess 132d at an area close proximity to the opening end thereof, is additionally formed. In such a modified form, as letting hook-shaped protruding portions 144a, formed on the upper wall 44 of the connector 40, to be guided in the associated guide recesses 132d, the protruding portions 144a are caused to move beyond the associated protruding portions 132e, after which the protruding portions 144a are brought into engagement with the associated protruding portions 132e, respectively. This allows the connector 40 to be placed in the case 30 in position determined in the longitudinal direction, the widthwise direction and the vertical direction with respect to the case 30. That is, the protruding portions 144a and the associated protruding portions 132e cooperate with each other to define an engagement section.

In such a modified form, therefore, in place of the fitting insertion portions 52b formed on the upper portions of the extending wall portions 52 of the connector 40 in the form of the horizontally protruding plate-like pieces set forth above, fitting insertion portions 152b may be respectively adopted with structures each in which a thickness thereof is reduced in the vertical direction as shown in FIGS. 5A and 6B. With such a structure, when the substrate 20 is completed in accommodation to the case 30, upper surfaces and lower surfaces of the fitting insertion portions 152b are set apart from the inner surface 30d of the high upper wall portion 32a of the case 30 and the upper surfaces of the fitting hold portions 36a. This results in improved inserting capability of the fitting insertion portions 152b when they are inserted into the associated fitting concave portions 36b of the case 30. In this connection, the filled resin layer 70 is formed in shape fully covering whole of circumferences of the fitting insertion portions 152b.

As shown in FIGS. 5B, 6C and 7, further, in place of the fitting hold portions 36a of the case 30 set forth above, fitting hold portions 136a may be respectively adopted with structures each in which a stepped portion 136c, which protrudes inward of the large accommodating chamber 30a of the case 30, is additionally formed. In such a modified form, when the substrate 20 is accommodated in the case 30, front end portions of the extending wall portions 52 of the connector 40 are brought into abutting contact with the stepped portions 136c, respectively. This allows the connector 40 to be placed in the case 30 in position determined in the longitudinal direction with respect to the case 30, in early.

In such a modified form, therefore, the guide recesses 132d, formed on the high upper wall portion 32a of the case 30, may be shortened in length in the longitudinal direction, and lengths of respective fitting insertion portions 252b may be shortened in the longitudinal direction, thereby making it possible to achieve a miniaturization in size. Incidentally, although the fitting insertion portions 252b are shown in structures having thin wall thickness in combination with the stepped portions 136c in FIG. 6C, of course, it doesn't matter if the fitting insertion portions 252b are not formed in thin walls like the fitting insertion portions 52b shown in FIG. 6A and the like.

Incidentally, the present invention is not limited to the embodiment set forth above in respect of the kind, location and number of relevant component members, and it is of course to be understood that modifications may be suitably made without departing from a scope of the present invention by suitably replacing relevant components with those having equivalent advantageous effects.

## Claims

1. An electronic control device (S) comprising:
a plurality of electronic components (10, 12) including a first electronic component (10) and a second electronic component (12);
a substrate (20) on which the plurality of electronic components are mounted;
a case (30) accommodating the substrate (20), on which the plurality of electronic components (10, 12) are mounted, in an accommodating chamber; and
a connector (40) mounted on the substrate (20) and entering into the accommodating chamber from an opening portion of the case, the case and the connector cooperating with each other to form a fitting section through which the connector is fitted to the case,
wherein
the first electronic component (10) has a height with respect to the substrate (20), which is higher than a height, with respect to the substrate, of the second electronic component (20), and the fitting section has a height with respect to the substrate (20), which is higher than the height, with respect to the substrate (20), of the first electronic component (10),
the first electronic component (10) is mounted on the substrate (20) in a gap portion defined between the fitting section and the substrate (20), the fitting section includes a fitting insertion portion (52b; 152b; 252b), formed on the connector (40), and a fitting concave portion (36b), formed on the case (30), to which the fitting insertion portion (52b; 152b; 252b) is inserted,
the fitting concave portion (36b) is defined between an inner surface of the case (30) and a fitting hold portion (36a; 136a) in a form of a horizontally protruding plate-like piece, protruding inward from inner surfaces (30d) of a side wall (36) of the case (30),
the fitting insertion portion (52b; 152b; 252b), in a form of a horizontal plate-like piece which protrudes outward from an upper portion of an extending wall (52) extending forward from a sidewall (48) of the connector (40) and beyond a front wall (50) of the connector (40), is inserted to the fitting concave portion (36b), the case (30) and the connector (40) cooperate with each other to form an engaging section, causing the connector (40) to engage the case (30),
a hook-shaped protruding portion (144a) and a hook-shaped protruding portion (132e) cooperate with each other to define the engaging section placed widthwisely inside with respect to the fitting insertion portion (52b; 152b; 252b), wherein the hook-shaped protruding portion (132e) protrudes downward from an upper surface of a guide recess (132d) formed on an inner surface of a high upper wall portion of the case (30), and the hook-shaped protruding portion (144a) is formed on an upper wall (44) of the connector (40),
and the first electronic component (10) is placed below the fitting hold portion (36a; 136a) in the gap portion.

2. The electronic control device (S) according to claim 1, wherein the fitting insertion portion(52b; 152b; 252b) is maintained under a state in which the fitting insertion portion(52b; 152b; 252b) kept in the fitting concave portion (36b) is spaced from the case with a state in which the engaging section causes the connector (40) to engage the case (30).

3. The electronic control device (S) according to claim 1, wherein the fitting hold portion (136a) includes a stepped portion (136c) with which the connector (40) is brought into abutting contact in an entering direction thereof with respect to the case (30).

4. The electronic control device (S) according to any of claims 1 to 3, wherein the case includes a first accommodating chamber (30a) and a second accommodating chamber (30b) less in capacity than the first accommodating chamber (30a) to allow the first electronic component (10) to be accommodated in the first accommodating chamber (30a) and the second electronic component (12) to be accommodated in the second accommodating chamber (30b).

## Patentansprüche

1. Elektronische Steuervorrichtung (S), umfassend:
mehrere elektronische Bauteile (10, 12), umfassend ein erstes elektronisches Bauteil (10) und ein zweites elektronisches Bauteil (12);
ein Substrat (20), auf dem die mehreren elektronischen Bauteile montiert sind;
ein Gehäuse (30), in dem das Substrat (20), auf dem die mehreren elektronischen Bauteile (10, 12) montiert sind, in einer Aufnahmekammer aufgenommen ist; und
einen Verbinder (40), der auf dem Substrat (20) montiert ist und von einem Öffnungsabschnitt des Gehäuses aus in die Aufnahmekammer eintritt, wobei das Gehäuse und der Verbinder miteinander zusammenwirken, um einen Passungsabschnitt zu bilden, durch den der Verbinder in das Gehäuse eingepasst wird, wobei
das erste elektronische Bauteil (10) eine Höhe in Bezug auf das Substrat (20) aufweist, die höher ist als eine Höhe des zweiten elektronischen Bauteils (20) in Bezug auf das Substrat, und der Passungsabschnitt eine Höhe in Bezug auf das Substrat (20) aufweist, die höher ist als die Höhe des ersten elektronischen Bauteils (10) in Bezug auf das Substrat (20),
das erste elektronische Bauteil (10) auf dem Substrat (20) in einem Spaltabschnitt montiert ist, der zwischen dem Passungsabschnitt und dem Substrat (20) definiert ist,
der Passungsabschnitt einen Passungseinführungsabschnitt (52b; 152b; 252b), der an dem Verbinder (40) ausgebildet ist, und einen konkaven Passungsabschnitt (36b), der an dem Gehäuse (30) ausgebildet ist, in den der Passungseinführungsabschnitt (52b; 152b; 252b) eingeführt ist, aufweist,
der konkave Passungsabschnitt (36b) zwischen einer Innenfläche des Gehäuses (30) und einem Passungshalteabschnitt (36a; 136a) in Form eines horizontal abstehenden, plattenartigen Teils, das von Innenflächen (30d) einer Seitenwand (36) des Gehäuses (30) nach innen absteht, definiert ist,
der Passungseinführungsabschnitt (52b; 152b; 252b), in Form eines horizontalen, plattenartigen Teils, das von einem oberen Abschnitt einer sich erstreckenden Wand (52), die sich von einer Seitenwand (48) des Verbinders (40) nach vorne und über eine Vorderwand (50) des Verbinders (40) hinaus erstreckt, nach außen absteht, in den konkaven Passungsabschnitt (36b) eingeführt ist,
das Gehäuse (30) und der Verbinder (40) miteinander zusammenwirken, um einen Eingriffsabschnitt zu bilden, der bewirkt, dass der Verbinder (40) mit dem Gehäuse (30) in Eingriff steht,
ein hakenförmiger, abstehender Abschnitt (144a) und ein hakenförmiger, abstehender Abschnitt (132e) miteinander zusammenwirken, um den Eingriffsabschnitt zu definieren, der in Breitenrichtung innen in Bezug auf den Passungseinführungsabschnitt (52b; 152b; 252b) angeordnet ist, wobei der hakenförmige, abstehende Abschnitt (132e) von einer oberen Fläche einer Führungsaussparung (132d), die an einer inneren Fläche eines höheren, oberen Wandabschnitts des Gehäuses (30) ausgebildet ist, nach unten absteht, und der hakenförmige, abstehende Abschnitt (144a) an einer oberen Wand (44) des Verbinders (40) ausgebildet ist,
und das erste elektronische Bauteil (10) unterhalb des Passungshalteabschnitts (36a; 136a) in dem Spaltabschnitt angeordnet ist.

2. Elektronische Steuervorrichtung (S) nach Anspruch 1, wobei der Passungseinführungsabschnitt (52b; 152b; 252b) in einem Zustand verbleibt, in dem der Passungseinführungsabschnitt (52b; 152b; 252b), der in dem konkaven Passungsabschnitt (36b) gehalten ist, von dem Gehäuse beabstandet ist, mit einem Zustand, in dem der Eingriffsabschnitt bewirkt, dass der Verbinder (40) mit dem Gehäuse (30) in Eingriff steht.

3. Elektronische Steuervorrichtung (S) nach Anspruch 1, wobei der Passungshalteabschnitt (136a) einen abgestuften Abschnitt (136c) aufweist, mit dem der Verbinder (40) in einer Eintrittsrichtung davon in Bezug auf das Gehäuse (30) in einen angrenzenden Kontakt gebracht ist.

4. Elektronische Steuervorrichtung (S) nach einem der Ansprüche 1 bis 3, wobei das Gehäuse eine erste Aufnahmekammer (30a) und eine zweite Aufnahmekammer (30b) mit einem geringeren Fassungsvermögen als die erste Aufnahmekammer (30a) aufweist, um die Aufnahme der ersten elektronischen Komponente (10) in der ersten Aufnahmekammer (30a) und die Aufnahme der zweiten elektronischen Komponente (12) in der zweiten Aufnahmekammer (30b) zu ermöglichen.

## Revendications

1. Dispositif de commande électronique (S) comprenant :
une pluralité de composants électroniques (10, 12) comportant un premier composant électronique (10) et un second composant électronique (12) ;
un substrat (20) sur lequel est montée la pluralité de composants électroniques ;
un boîtier (30) accueillant le substrat (20), sur lequel est montée la pluralité de composants électroniques (10, 12), dans une chambre d'accueil ; et
un connecteur (40) monté sur le substrat (20) et entrant dans la chambre d'accueil à partir d'une partie d'ouverture du boîtier, le boîtier et le connecteur coopérant l'un avec l'autre pour former une section de raccordement à travers laquelle le connecteur est raccordé au boîtier,
dans lequel le premier composant électronique (10) a une hauteur par rapport au substrat (20), laquelle est supérieure à une hauteur, par rapport au substrat, du second composant électronique (20), et la section de raccordement a une hauteur par rapport au substrat (20), qui est supérieure à la hauteur, par rapport au substrat (20), du premier composant électronique (10),
le premier composant électronique (10) est monté sur le substrat (20) dans une partie d'espace définie entre la section de raccordement et le substrat (20), la section de raccordement comporte une partie d'insertion de raccordement (52b ; 152b ; 252b), formée sur le connecteur (40), et une partie concave de raccordement (36b), formée sur le boîtier (30), dans laquelle est insérée la partie d'insertion de raccordement (52b ; 152b ; 252b),
la partie concave de raccordement (36b) est définie entre une surface intérieure du boîtier (30) et une partie de maintien de raccordement (36a ; 136a) sous la forme d'une pièce en forme de plaque saillante horizontalement, dépassant vers l'intérieur à partir de surfaces internes (30d) d'une paroi latérale (36) du boîtier (30),
la partie d'insertion de raccordement (52b ; 152b ; 252b), sous forme de pièce en forme de plaque horizontale qui dépasse vers l'extérieur à partir d'une partie supérieure d'une paroi étendue (52) s'étendant vers l'avant à partir d'une paroi latérale (48) du connecteur (40) et au-delà d'une paroi avant (50) du connecteur (40), est insérée dans la partie concave de raccordement (36b), le boîtier (30) et le connecteur (40) coopèrent l'un avec l'autre pour former une section d'enclenchement, amenant le connecteur (40) à s'enclencher avec le boîtier (30),
une partie saillante en forme de crochet (144a) et une partie saillante en forme de crochet (132e) coopèrent l'une avec l'autre pour définir la section d'enclenchement placée dans le sens de la largeur à l'intérieur par rapport à la partie d'insertion de raccordement (52b ; 152b ; 252b) , dans lequel la partie saillante en forme de crochet (132e) dépasse vers le bas à partir d'une surface supérieure d'un renfoncement de guidage (132d) formé sur une surface interne d'une partie de paroi supérieure haute du boîtier (30), et la partie saillante en forme de crochet (144a) est formée sur une paroi supérieure (44) du connecteur (40), et le premier composant électronique (10) est placé sous la partie de maintien de raccordement (36a ; 136a) dans la partie d'espace.

2. Dispositif de commande électronique (S) selon la revendication 1, dans lequel la partie d'insertion de raccordement (52b ; 152b ; 252b) est maintenue dans un état dans lequel la partie d'insertion de raccordement (52b ; 152b ; 252b) maintenue dans la partie concave de raccordement (36b) est espacée du boîtier avec un état dans lequel la section d'enclenchement amène le connecteur (40) à s'enclencher dans le boîtier (30).

3. Dispositif de commande électronique (S) selon la revendication 1, dans lequel la partie de maintien de raccordement (136a) comprend une partie graduée (136c) avec laquelle le connecteur (40) est mis en contact abouté dans une direction d'introduction de celui-ci par rapport au boîtier (30).

4. Dispositif de commande électronique (S) selon l'une quelconque des revendications 1 à 3, dans lequel le boîtier comprend une première chambre d'accueil (30a) et une seconde chambre d'accueil (30b) de capacité inférieure à la première chambre d'accueil (30a) pour permettre d'accueillir le premier composant électronique (10) dans la première chambre d'accueil (30a) et d'accueillir le second composant électronique (12) dans la seconde chambre d'accueil (30b).
